# EUROPEAN PATENT SPECIFICATION

(11) **EP 2 637 305 B1**
(45) Date of publication and mention of the grant of the patent: **10.11.2021**
(21) Application number: 12158851.1
(22) Date of filing: 09.03.2012
(51) Int. Cl.: H03K 17/16

(54) **Control circuitry for controlling a semiconductor switch**
Steuerschaltung zur Steuerung eines Halbleiterschalters
Circuit de contrôle pour la commande d'un commutateur semi-conducteur

(43) Date of publication of application: 11.09.2013
(73) Proprietor: Aros Electronics AB, 431 53 Mölndal (SE)
(72) Inventor: Hellström, Jerker, 449 44 Nol (SE)
(74) Representative: AWA Sweden AB

(56) References cited:
- WO-A2-2007/120604
- US-A- 5 663 667
- US-A1- 2010 061 124
- None

## Description

### Field of the Invention

The present invention generally relates to control of electrical devices, specifically to an electrical control circuitry and corresponding switching scheme for controlling the electric device at different phases of operation.

### Technical Background

Methods for controlling and providing power to electrical devices, for example arranged in a vehicle, such as light sources, electrical motors, inductors, capacitors, etc. have traditionally included the use of operational switches and electrical relays. However, already in the late 1980's, electrical power switches comprising field-effect transistors was introduced, thereby minimizing e.g. problems relating to mechanical issues with electrical relays.

The use of field-effect transistors in a power switch has been proven attractive since such an implementation results in a more compact implementation, saving space and cost. Furthermore, by using a combination of a plurality of field-effect transistors arranged in a bridge configuration, it is possible to provide further enhancements in control of electrical devices. An example of such an implementation is the half-bridge configuration where the inherent characteristics of the field-effect transistor allow for providing a smoother control of for example an electrical motor.

Further advantages with power switches comprising field-effect transistors includes the possibility of fast switching for changing an operational state of the electrical device (e.g. between on and off), at the same time as field-effect transistors allows for switching of high currents.

However, even though high currents may be switched at high speed, in some states of operation of selected electrical devices the maximum rated power dissipation of the field-effect transistors may be exceeded, potentially damaging the field-effect transistor, or at least decreasing its lifetime. This is in some power switch implementations handled by introducing current limitations and/or temperature control of the field-effect transistors. Such limitations will however limit the usefulness of the power switch, as well as introducing unreliability when controlling an electrical device by means of the power switch.

Accordingly there is a need for an improved switching scheme for controlling one or a plurality of field-effect transistors arranged in a power switch, where the switching scheme allows for controlling an electrical device during all states of operation.

WO 2007/120604 A2 discloses an integrated voltage regulator with amplitude modulation of the input voltage and slew rate modulation of the output voltage.

US 2010/061124 A1 discloses a power supply converter with current sense signal, whereby the converter is switched off if the current sense signal is above a certain threshold voltage.

### Summary of the Invention

According to a first aspect of the present invention, there is provided a system according to independent claim 1.

The present invention is based on the realization that a load connected to the power switch, such as an electrical device comprising a light source, inductor, capacitor, etc., may undergo different stages during its operation. For example, when turning on a light source, the internal resistance of the light source will dynamically increase during a start-up process of the light source, posing a potential problem in early part of the start-up phase, as the at that point in time low resistance increases the current flow through the first semiconductor switch, possibly reaching levels resulting in a power dissipation at the semiconductor switch exceeding the maximum rated level.

This is solved by the invention through the selection of a slew rate (i.e. rise and/or fall time) for the control signal controlling the first semiconductor switch, in an embodiment being semiconductor switch based on MOSFET technology, such as for example a power MOSFET, where the slew rate is adjusted based on a current flowing though at least one of the semiconductor switch and the load, e.g. being the above discussed light source.

Specifically, as the semiconductor switch during short periods of time may be able to handle higher currents than what is possible during, in comparison, longer periods of time, it is possible to switch the semiconductor switch differently during the start-up phase (i.e. by means of the second predefined slew rate, being an in relation high slew rate) than during the general operational phase (i.e. where an in relation lower slew rate is selected being the first predefined slew rate) of e.g. the light source or any other electrical device. Accordingly, the maximum peak current level is preferably determined based on the specification of the semiconductor switch.

The proposed switching scheme allows for a more reliable control of the electrical device as well as only introducing a minimum amount of high frequency switching noise generally induced by switching at high slew rates (over tones, etc.), since the time period when high slew rates for the control signal is applied is minimized to the time it takes to start-up the electrical device. Thus, preferably, the control circuitry is further configured to continuously switching the semiconductor switch between its conductive and non-conductive state, using the control signal having the second predefined slew rate, as long as it is determined that the electrical peak current level is above the predefine maximum peak current level.

The control circuitry may further be configured to monitoring the duration of the continuously switching of the semiconductor switch, and switching the semiconductor switch to the non-conductive state if the duration is longer than a first predefined time period. Accordingly, in case of a short circuit, it is possible to "turn off" the semiconductor switch when a short duration has passed, possibly indicating/communicating the presence of the short circuit to a system where the control circuitry forms an integral element.

In one embodiment, the control circuitry may further be configured to switch the semiconductor, using the control signal having the first predefined slew rate, if it is determined that the electrical peak current level has been below the predefined maximum peak current level for a predetermined time period. Thus, in case it is determined that the current level decreases, e.g. the light source is getting warmer and its resistance increases, the slew rate may once again be lowered for minimizing any high frequency switching noise.

It should be understood that the predetermined time period relates to the time it takes for e.g. the light source to get warmer and enter its "normal" operational mode. During the "initial operation" (when e.g. the light source is cold), the current level will essentially fluctuate between 0 and the maximum peak current level, and it is during this initial operation that the semiconductor switch will be controlled using the control signal having the second predefined slew rate

In an alternative embodiment of the invention, the control circuitry is further configured to keep the semiconductor switch in the non-conductive state for a second predefined time period before switching the semiconductor switch to the conductive state. Such an embodiment allows for controlling the rms and mean value of the current. Preferably, this also handles the case where longer cabling and possible inductances are involved, and accordingly the current flow is not directly cut off as when dealing with e.g. solely resistive loads.

Preferably, the electrical control circuitry is arranged to control a a second semiconductor switch, where the two semiconductor switches are arranged in a half bridge configuration. Advantages with such a configuration may include an even more reliable control of specific types of loads, including for example electrical motors, inductors, capacitors, etc., and will be discussed further below in the detailed description.

For allowing high slew rates for the control signal, the control circuitry is preferably configured for also adjusting a current level of the control signal. Such functionality may for example be implemented as introduced below in relation to the detailed description.

According to another aspect of the present invention, it is provided a method according to independent claim 8.

Further effects and features of this aspect of the present invention are largely analogous to those described above in connection with the first aspect of the invention.

Other objectives, features, and advantages of the present invention will appear from the following detailed disclosure, from the attached dependent claims as well as from the drawings.

### Brief Description of the Drawings

These and other aspects of the present invention will now be described in more detail with reference to the appended drawings showing an example embodiment of the invention, wherein:
Fig. 1 schematically exemplifies a switching system according to a currently preferred embodiment of the invention;
Fig. 2a and 2b provides diagrams illustrating a control signal for controlling a semiconductor switch;
Fig. 3 illustrates an alternative embodiment of a switching system, and
Fig. 4 is a flow chart outlining the general steps of a method according to a currently preferred embodiment of the invention.

### Detailed Description of Preferred Embodiments of the Invention

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness. Like reference characters refer to like elements throughout.

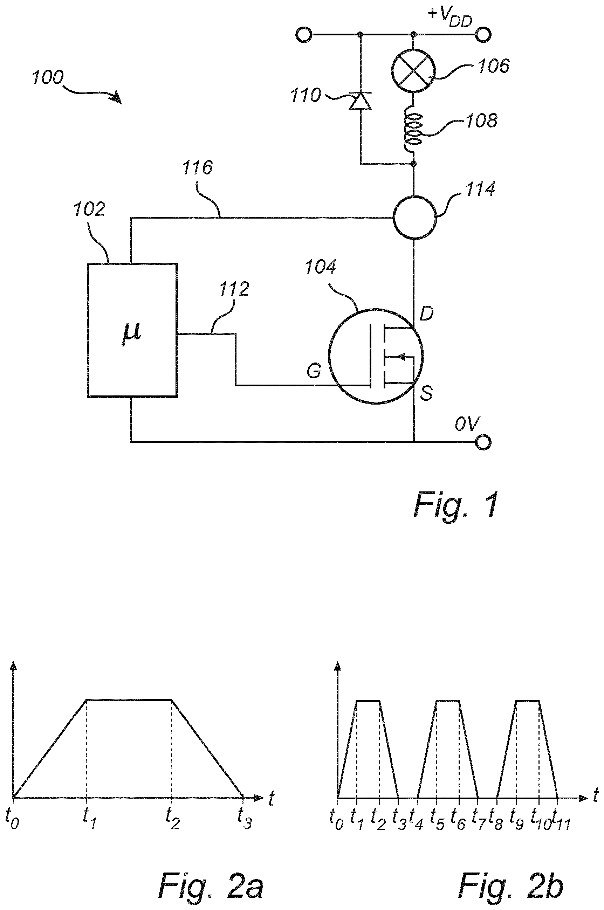

Turning now to the drawings and to Fig. 1 in particular, there is schematically illustrated a switching system 100 comprising an electrical control circuitry 102 connected to and provided for controlling a semiconductor switch 104. Furthermore, the switching system 100 comprises a load, in the illustrated embodiment provided as a light source 106. The switching system 100 further comprises an inductor 108 arranged in series with the light source 106, and a diode 110 arranged in parallel with the light source 106 and the inductors 108.

In Fig. 1 the semiconductor switch 104 is illustrated as an N-channel MOSFET configured to switch a supply voltage +V_{DD} across the inductor 108 and the light source 106 between an "ON" and "OFF" state. During operation, the gate input voltage V_{GS} is taken to an appropriate positive voltage level to turn the semiconductor device 104 and therefore the light source 106 either fully "ON" (V_{GS} = HIGH), or at a zero voltage level that turns the semiconductor device 104 fully "OFF" (VGS = 0), by means of a control signal 112 provided by the control circuit 102 and connected to the gate of the semiconductor switch 104. The inductor is used to store energy when the semiconductor switch 104 is switched on; this energy is then used to provide current for the light source 106 when the semiconductor switch 104 is switched off. The diode 110 across the light source 106 and the inductor 108 provides a return path for the current during the semiconductor off time.

For the semiconductor switch 104 to operate as an analogue switching device, it needs to be switched between its "Cut-off Region" where V_{GS} = 0 and its "Saturation Region" were V_{GS} = HIGH. The power dissipated in the semiconductor device 104 (P_{D}) depends upon the current flowing through the drain-source channel I_{D} at saturation and is also based the "ON-resistance" of the channel given as R_{DS(on)}.

For example, in one implementation the light source 106 is rated at 24 Volts (e.g. in relation to the automotive industry) and having a resistance (when warm) at 5 Ω. Additionally, when fully "ON", the semiconductor switch 104 has a channel "ON-resistance" (R_{DS(on)}) of 3 mΩ. The current flowing through the channel I_{D} at saturation would thus be based on the voltage rating and resistance of the light source 106, i.e. I_{D} = V_{light source} / R_{light source} = 24 V / 5 Ω = 4.8 A. Accordingly, the power dissipation (warm light source) within the semiconductor switch 104 will be based on the current flowing through the channel I_{D} and the channel "ON-resistance" (R_{DS(on)}) value, i.e. P_{D} = I_{D}² × R_{DS(on)} = 4.8²A × 3 mΩ = 6.9 mW. Thus, the semiconductor switch 104 has only to take care of a very small amount of power, for dissipation, and there is no risk for exceeding a typical maximum rated level of the semiconductor switch 104.

However, when turning on a cold light source 106, the internal resistance of the light source is different, e.g. in one example only 0.1 Ω, resulting in completely different results of the calculation. That is, I_{D} = V_{light} source / R_{light source} = 24 V / 0.1 Ω = 240 A. Such a high current risk to damage cables, contact and other components for example limited to 10 A. In case of implementing a current limitation, for example by means of configuring the semiconductor switch 104 to handle the voltage up to e.g. 50 A, the losses will be defined by first determining the voltage over the light source 106 as 50 A × 0.1 Ω = 5 V, where the remaining voltage will be provided over the semiconductor switch 104, i.e. 24 V - 5 V = 19 V, giving an efficient power dissipation at the semiconductor switch 104 of P_{D} = 19 V × 50 A = 950 W. Such high power dissipation may only be handled by the semiconductor switch 104 for a brief moment, i.e. within the range of 10 - 100 µs. The process of turning "ON" the light source 106, i.e. from cold to warm, generally takes from 20 - 50 ms, and hence the semiconductor switch 104 will be damaged.

In Fig. 1 this is handled by monitoring the current flowing through at least one of the load or the semiconductor switch 104 channel I_{D}, in the example using a current sensing device 114 connected to the control circuitry 102. The current sensing device 114 may for example be implemented as a shunt or any other suitable configuration, e.g. a general resistor, where the providing a feedback 116 to the control circuitry 102 which is configured to extract and determine a current level.

According to the principle outlined above, the inductor 108 will be passive during the time periods of low frequency switching, if selecting the inductance to be e.g. within the range of 100 - 500 nH. However, during time periods of high frequency switching the inductance comes into play and the switching system 100 starts to function as a Buck converter, where the diode 110 functioning as a free wheel diode providing a return path for the current during the semiconductor off time.

According to the invention, the determined current level will be used by the control circuitry 102 for "slowly" turning on the light source 106, i.e. in short sequences. That is, the light source 106 will during "startup" only be kept on for such short time periods that is possible to handle by the semiconductor switch 104, e.g. in durations of less than 100 µs. Generally, turning on the light source 106 according to this schedule will take (less than) approximately 100 ms.

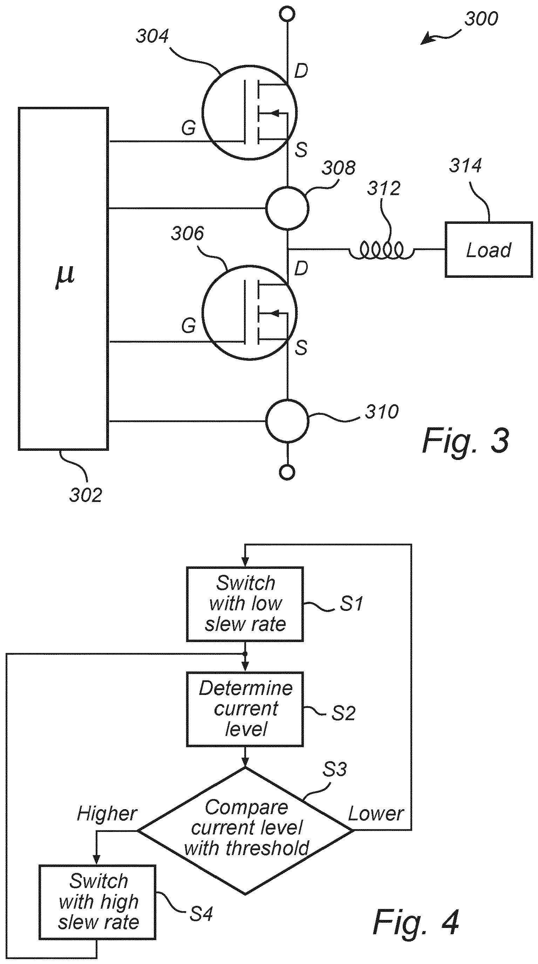

With further reference to Figs. 2a and 2b in conjunction with Fig. 4, for minimizing any disturbances generated, e.g. in an automotive electrical system, it is desirable to keep the switching to a minimum, and additionally keep any switching as slow as possible for minimizing the risk of introducing overtones on the automotive electrical system. Generally, the control signal 112 provided by the control circuitry 102 for controlling the semiconductor switch 104 is switched, S1, using a low slew rate, i.e. a rise and fall time, e.g. as exemplified in Fig. 2a. In Fig. 2a, the rise time t₀ - t₁ as well as the fall time t₂ - t₃ is kept around 200 µs, resulting in a minimal amount of disturbance and overtones.

However, during the startup of e.g. the light source 106, such rise and fall time will be too long. According to the invention, when it is sensed and determined, S2, using the current sensing device 114 that the current level is above a predetermined maximum peak level, S3, the switching of the control signal 112 for controlling the semiconductor switched 104 is changed for example as is illustrated in Fig. 2b. In Fig. 2b the control signal 1112 is illustrated to be switched using an in relation high slew rate, S4, e.g. where the rise time t₀ - t₁ as well as the fall time t₂ - t₃ is kept around 1 µs or lower.

That is, when it is sensed that the current level is above the predetermined maximum peak level the switching scheme will be adjusted, and the semiconductor switch 104 will fast and with a high slew rate be switched ON and OFF for short time periods (i.e. t₄ - t₁₁ and so on), possibly with a switching frequency of around 10- 100 kHz. The fast switching will take place until e.g. the light source 106 has become warm and the current sensing device 114 senses that the current level is below the predetermined maximum peak level for a predetermined time period. Then, the switching scheme will again be adjusted back to possible switching of the control signal 112 with the, in relation, low slew rate effectively minimizing any disturbances. As the total time period for turning ON the light source 106 generally is less than 100 ms, or even less than 50 or 20 ms (depending on the average current provided when switching at the high speed switching), the disturbance within e.g. the automotive electrical system may possibly be neglected.

The control circuitry 102 may include a microprocessor, a microcontroller, a programmable digital signal processor or another programmable device. The control circuitry 102 may also, or instead, include an application specific integrated circuit (ASIC), a programmable gate array programmable array logic, a programmable logic device, or a digital signal processor. Where the control circuitry 102 includes a programmable device such as the microprocessor or microcontroller mentioned above, the processor may further include computer executable code that controls operation of the programmable device. The control circuitry 102 is preferably also configured to monitor the duration at which the high speed switching takes place, and forces the switching to stop (i.e. V_{GS} = 0) after e.g. 100/50/20 ms, depending on the specific implementation, possibly being an indication of a short circuit.

It should be noted that the load may be any type of electronic device, including the light source 106, a capacitor (not shown) or an inductor (such as a motor, not shown). However, the principal of the above discussed adjustable switching scheme is valid also for these types of loads.

In Fig. 3 there is provided an alternative implementation of a switching system 300, comprising a control circuitry 302 and two semiconductor switches 304, 306 arranged in a half-bridge configuration. The switching system 300 further comprises two respective current sensing devices 308, 310 connected to the control circuitry 302. Additionally, the switching system 300 comprises an inductor 312 connected between a common point of the half-bridge configuration and a load 314.

During operation, as presented above, the inductor 312 will be passive during the time periods of low frequency switching and come into play only during time periods of high frequency switching. Here, the semiconductor switch 306 will function as the Buck converter's free wheel diode in a corresponding manner as the diode 110 of Fig. 1. By means of such an implementation the efficiency of the switching system 300 may be further increased.

The person skilled in the art realizes that the present invention by no means is limited to the preferred embodiments described above. On the contrary, many modifications and variations are possible within the scope of the appended claims. Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A system comprising:
a semiconductor switch (104; 304) arranged to supply electrical power from a power source (+V_{DD}) to a load (106; 314) connected to an output terminal of the semiconductor switch,
an electrical control circuitry (102; 302) configured to provide a control signal (112) for switching the semiconductor switch (104; 304) with a first predefined slew rate selected to avoid disturbances and overtones in a normal operation mode;
a current sensing device (114; 308, 310) for determining an electrical peak current level in at least one of the load (106; 314) and the semiconductor switch (104; 304);
wherein at start-up the electrical control circuitry (102; 302) is configured to:
- switch, using the control signal (112), the semiconductor switch (104; 304) from the non-conductive state to the conductive state, the control signal having the first predefined slew rate,
- compare the electrical peak current level with a predefined maximum peak current level, and
- if said electrical peak current is above said predefined maximum peak current level, to switch, using the control signal (112), the semiconductor switch (104; 304) from the conductive state to the non-conductive state, the control signal (112) having a second predefined slew-rate, said second predefined slew rate being higher than said first slew rate, and then switch, using the control signal (112), the semiconductor (104; 304) switch from the non-conductive state to the conductive state, the control signal (112) having a second predefined slew-rate, and
- if said electrical peak current is below said predefined maximum peak current level, to switch, using the control signal (112), the semiconductor switch(104; 304), the control signal (112) having the first predefined slew-rate.

2. The system according to claim 1, wherein the control circuitry (102) is further configured to monitor the duration of the switching of the semiconductor switch using said second slew rate, and switching the semiconductor switch to the non-conductive state if the duration is longer than a first predefined time period.

3. The system according to any one of claims 1 ― 2, wherein the control circuitry (102) is further configured to switch the semiconductor, using the first predefined slew rate, if it is determined that the electrical peak current level has been below the predefined maximum peak current level for a predetermined time period.

4. The system according to any one of claims 1 - 3, wherein the control circuitry (102) is further configured to keep the semiconductor switch in the non-conductive state for a second predefined time period before switching the semiconductor switch to the conductive state.

5. The system according to any one of the preceding claims, wherein said current sensing device (114) comprises a current shunt resistor.

6. The system according to any one of the preceding claims, further comprising a second semiconductor switch (306), together with the semiconductor switch (304) forming a half bridge configuration.

7. The system according to any one of the preceding claims, wherein the semiconductor switch (104; 304, 306) is based on MOSFET technology.

8. A method for controlling a semiconductor switch (104; 304) arranged to supply electrical power from a power source (+V_{DD}) to a load (106; 314) connected to an output terminal of the semiconductor switch (104; 304), wherein the method comprises the steps of:
- switching, using a control signal (112), the semiconductor switch (104; 304) with a first predefined slew rate selected to avoid disturbances and overtones in a normal operation mode and;
- using a current sensing device (114; 308, 310) to determine (step S2) an electrical peak current level in at least one of the load (106; 314) and the semiconductor switch (104; 304);
wherein at start-up the method further comprises the steps of:
- comparing (step S3) the electrical peak current level with a predefine maximum peak current level;
- if said electrical peak current is above said predefined maximum peak current level, switching, using the control signal (112), the semiconductor switch (104; 304) from the conductive state to the non-conductive state, the control signal (112) having a second predefined slew-rate, said second predefined slew rate being higher than said first slew rate, and then switching, using the control signal (112), the semiconductor (104; 304) switch from the non-conductive state to the conductive state, the control signal (112) having a second predefined slew-rate, and
- if said electrical peak current is below said predefined maximum peak current level, switching, using the control signal (112), the semiconductor switch(104; 304), the control signal (112) having the first predefined slew-rate.

9. The method according to claim 8, further comprising the steps of:
- monitoring the duration of the switching of the semiconductor switch using said second slew rate, and
- switching the semiconductor switch to the non-conductive state if the duration is longer than a first predefined time period.

10. The method according to any one of claims 8 - 9, further comprising again switching the semiconductor using the first predefined slew rate, if it is determined that the electrical peak current level has been below the predefine maximum peak current level for a predetermined time period.

11. The method according to any one of claims 8 - 9, further comprising the step of keeping the semiconductor switch in the non-conductive state for a second predefined time period before switching the semiconductor switch to the conductive state.

## Patentansprüche

1. System, das umfasst:
einen Halbleiterschalter (104; 304), der dafür ausgelegt ist, elektrischen Strom von einer Stromquelle (+V_{DD}) zu einer Last (106; 314), die mit einem Ausgangsanschluss des Halbleiterschalters verbunden ist, fließen zu lassen,
eine elektrische Steuerschaltung (102; 302), die dafür konfiguriert ist, ein Steuersignal (112) zum Schalten des Halbleiterschalters (104; 304) mit einer ersten vorgegebenen Anstiegsgeschwindigkeit bereitzustellen, die so gewählt wird, dass Störungen und Oberschwingungen in einem normalen Betriebsmodus vermieden werden;
eine Stromabfühlvorrichtung (114; 308, 310) zum Bestimmen eines elektrischen Spitzenstrompegels in mindestens einem der Last (106; 314) und dem Halbleiterschalter (104; 304);
wobei die elektrische Steuerschaltung (102; 302) dafür konfiguriert ist, beim Start:
- den Halbleiterschalter (104; 304) unter Verwendung des Steuersignals (112) vom nicht-leitenden Zustand in den leitenden Zustand zu schalten, wobei das Steuersignal die erste vorgegebene Anstiegsgeschwindigkeit aufweist,
- den elektrischen Spitzenstrompegel mit einem vorgegebenen maximalen Spitzenstrompegel zu vergleichen, und
- wenn der elektrische Spitzenstrom über dem vorgegebenen maximalen Spitzenstrompegel liegt, den Halbleiterschalter (104; 304) unter Verwendung des Steuersignals (112) von dem leitenden Zustand in den nicht-leitenden Zustand zu schalten, wobei das Steuersignal (112) eine zweite vorgegebene Anstiegsgeschwindigkeit aufweist, wobei die zweite vorgegebene Anstiegsgeschwindigkeit höher ist als die erste Anstiegsgeschwindigkeit, und dann den Halbleiterschalter (104; 304) unter Verwendung des Steuersignals (112) von dem nicht-leitenden Zustand in den leitenden Zustand zu schalten, wobei das Steuersignal (112) eine zweite vorgegebene Anstiegsgeschwindigkeit aufweist, und
- wenn der elektrische Spitzenstrom unter dem vorgegebenen maximalen Spitzenstrompegel liegt, den Halbleiterschalter (104; 304) unter Verwendung des Steuersignals (112) zu schalten, wobei das Steuersignal (112) die erste vorgegebene Anstiegsgeschwindigkeit aufweist.

2. System nach Anspruch 1, wobei die Steuerschaltung (102) des Weiteren dafür konfiguriert ist, die Dauer des Schaltens des Halbleiterschalters unter Verwendung der zweiten Anstiegsgeschwindigkeit zu überwachen und den Halbleiterschalter in den nicht-leitenden Zustand zu schalten, wenn die Dauer länger als eine erste vorgegebene Zeitspanne ist.

3. System nach einem der Ansprüche 1 und 2, wobei die Steuerschaltung (102) des Weiteren dafür konfiguriert ist, den Halbleiter unter Verwendung der ersten vorgegebenen Anstiegsgeschwindigkeit zu schalten, wenn festgestellt wird, dass der elektrische Spitzenstrompegel eine zuvor festgelegte Zeitspanne lang unter dem vorgegebenen maximalen Spitzenstrompegel gelegen hat.

4. System nach einem der Ansprüche 1 bis 3, wobei die Steuerschaltung (102) des Weiteren dafür konfiguriert ist, den Halbleiterschalter eine zweite vorgegebene Zeitspanne lang in dem nicht-leitenden Zustand zu halten, bevor der Halbleiterschalter in den leitenden Zustand geschaltet wird.

5. System nach einem der vorangehenden Ansprüche, wobei die Stromabfühlvorrichtung (114) einen Strom-Nebenschlusswiderstand umfasst.

6. System nach einem der vorangehenden Ansprüche, das des Weiteren einen zweiten Halbleiterschalter (306) umfasst, der zusammen mit dem Halbleiterschalter (304) eine Halbbrückenkonfiguration bildet.

7. System nach einem der vorangehenden Ansprüche, wobei der Halbleiterschalter (104; 304, 306) auf MOSFET-Technologie basiert.

8. Verfahren zum Steuern eines Halbleiterschalters (104; 304), der dafür ausgelegt ist, elektrischen Strom von einer Stromquelle (+V_{DD}) zu einer Last (106; 314), die mit einem Ausgangsanschluss des Halbleiterschalters (104; 304) verbunden ist, fließen zu lassen, wobei das Verfahren die folgenden Schritte umfasst:
- Schalten des Halbleiterschalters (104; 304) unter Verwendung eines Steuersignals (112) mit einer ersten vorgegebenen Anstiegsgeschwindigkeit, die so gewählt wird, dass Störungen und Oberschwingungen in einem normalen Betriebsmodus vermieden werden; und
- Verwenden einer Stromabfühlvorrichtung (114; 308, 310) zum Bestimmen (Schritt S2) eines elektrischen Spitzenstrompegels in mindestens einem der Last (106; 314) und dem Halbleiterschalter (104; 304);
wobei das Verfahren beim Starten des Weiteren die folgenden Schritte umfasst:
- Vergleichen (Schritt S3) des elektrischen Spitzenstrompegels mit einem vorgegebenen maximalen Spitzenstrompegel;
- wenn der elektrische Spitzenstrom über dem vorgegebenen maximalen Spitzenstrompegel liegt, Schalten des Halbleiterschalters (104; 304) unter Verwendung des Steuersignals (112) von dem leitenden Zustand in den nicht-leitenden Zustand, wobei das Steuersignal (112) eine zweite vorgegebene Anstiegsgeschwindigkeit aufweist, wobei die zweite vorgegebene Anstiegsgeschwindigkeit höher ist als die erste Anstiegsgeschwindigkeit, und dann Schalten des Halbleiterschalters (104; 304) unter Verwendung des Steuersignals (112) von dem nicht-leitenden Zustand in den leitenden Zustand, wobei das Steuersignal (112) eine zweite vorgegebene Anstiegsgeschwindigkeit aufweist, und
- wenn der elektrische Spitzenstrom unter dem vorgegebenen maximalen Spitzenstrompegel liegt, Schalten des Halbleiterschalters (104; 304) unter Verwendung des Steuersignals (112), wobei das Steuersignal (112) die erste vorgegebene Anstiegsgeschwindigkeit aufweist.

9. Verfahren nach Anspruch 8, das des Weiteren folgende Schritte umfasst:
- Überwachen der Dauer des Schaltens des Halbleiterschalters unter Verwendung der zweiten Anstiegsgeschwindigkeit, und
- Umschalten des Halbleiterschalters in den nicht-leitenden Zustand, wenn die Dauer länger als eine erste vorgegebene Zeitspanne ist.

10. Verfahren nach einem der Ansprüche 8 und 9, das des Weiteren umfasst, den Halbleiter erneut unter Verwendung der ersten vorgegebenen Anstiegsgeschwindigkeit zu schalten, wenn festgestellt wird, dass der elektrische Spitzenstrompegel eine zuvor festgelegte Zeitspanne lang unter dem vorgegebenen maximalen Spitzenstrompegel gelegen hat.

11. Verfahren nach einem der Ansprüche 8 und 9, das des Weiteren den Schritt umfasst, den Halbleiterschalter eine zweite vorgegebene Zeitspanne lang in dem nicht-leitenden Zustand zu halten, bevor der Halbleiterschalter in den leitenden Zustand geschaltet wird.

## Revendications

1. Système comprenant :
un commutateur à semi-conducteurs (104 ; 304) agencé pour fournir de l'énergie électrique d'une source d'alimentation (+V_{DD}) à une charge (106 ; 314) connectée à une borne de sortie du commutateur à semi-conducteurs,
un circuit de commande électrique (102 ; 302) configuré pour fournir un signal de commande (112) pour commuter le commutateur à semi-conducteurs (104 ; 304) avec une première vitesse de balayage prédéfinie sélectionnée pour éviter les perturbations et les harmoniques dans un mode de fonctionnement normal ;
un dispositif de détection de courant (114 ; 308, 310) pour déterminer un niveau de courant de crête électrique dans au moins un de la charge (106 ; 314) et du commutateur à semi-conducteur (104; 304) ; dans lequel au démarrage le circuit de commande électrique (102 ; 302) est configuré pour :
- commuter, à l'aide du signal de commande (112), le commutateur à semi-conducteurs (104 ; 304) de l'état non conducteur à l'état conducteur, le signal de commande ayant la première vitesse de balayage prédéfinie,
- comparer le niveau de courant de crête électrique avec un niveau de courant de crête maximal prédéfini, et
- si ledit courant de crête électrique est supérieur audit niveau de courant de crête maximal prédéfini, faire passer, à l'aide du signal de commande (112), le commutateur à semi-conducteurs (104 ; 304) de l'état conducteur à l'état non conducteur, le signal de commande (112) ayant une deuxième vitesse de balayage prédéfinie, ladite deuxième vitesse de balayage prédéfinie étant supérieure à ladite première vitesse de balayage, puis commuter, à l'aide du signal de commande (112), le commutateur à semi-conducteurs (104 ; 304) de l'état non conducteur à l'état conducteur, le signal de commande (112) ayant une deuxième vitesse de balayage prédéfinie, et
- si ledit courant de crête électrique est inférieur audit niveau de courant de crête maximum prédéfini, commuter, à l'aide du signal de commande (112), le commutateur à semi-conducteurs (104 ; 304), le signal de commande (112) ayant la première vitesse de balayage.

2. Système selon la revendication 1, dans lequel les circuits de commande (102) sont en outre configurés pour surveiller la durée de la commutation du commutateur à semi-conducteurs en utilisant ladite deuxième vitesse de balayage, et pour commuter le commutateur à semi-conducteurs dans l'état non conducteur si la durée est plus longue qu'une première période de temps prédéfinie.

3. Système selon une quelconque des revendications 1 à 2, dans lequel le circuit de commande (102) est en outre configuré pour commuter le commutateur à semi-conducteurs, en utilisant la première vitesse de balayage prédéfinie, s'il est déterminé que le niveau de courant de crête électrique a été inférieur au niveau de courant de crête maximal prédéfini pendant une période de temps prédéterminée.

4. Système selon une quelconque des revendications 1 à 3, dans lequel le circuit de commande (102) est en outre configuré pour maintenir le commutateur à semi-conducteurs dans l'état non conducteur pendant une deuxième période de temps prédéfinie avant de commuter le commutateur à semi-conducteurs sur l'état conducteur.

5. Système selon une quelconque des revendications précédentes, dans lequel ledit dispositif de détection de courant (114) comprend une résistance en dérivation de courant.

6. Système selon une quelconque des revendications précédentes, comprenant en outre un deuxième commutateur à semi-conducteurs (306), conjointement au commutateur à semi-conducteurs (304) formant une configuration en demi-pont.

7. Système selon une quelconque des revendications précédentes, dans lequel le commutateur à semi-conducteurs (104 ; 304, 306) est basé sur la technologie MOSFET.

8. Procédé de commande d'un commutateur à semi-conducteurs (104 ; 304) conçu pour fournir de l'énergie électrique à partir d'une source d'alimentation (+V_{DD}) à une charge (106 ; 314) connectée à une borne de sortie du commutateur à semi-conducteurs (104 ; 304), dans lequel le procédé comprend les étapes de :
- commutation, à l'aide d'un signal de commande (112), du commutateur à semi-conducteur (104 ; 304) avec une première vitesse de balayage prédéfinie sélectionnée pour éviter les perturbations et les harmoniques dans un mode de fonctionnement normal et
- l'utilisation d'un dispositif de détection de courant (114 ; 308, 310) pour déterminer (étape S2) un niveau de courant de crête électrique dans au moins un de la charge (106 ; 314) et du commutateur à semi-conducteur (104 ; 304) ;
dans lequel, au démarrage, le procédé comprend en outre les étapes de:
- comparaison (étape S3) du niveau de courant de crête électrique avec un niveau de courant de crête maximal prédéfini ;
- si ledit courant de crête électrique est supérieur audit niveau de courant de crête maximal prédéfini, le passage, à l'aide du signal de commande (112), du commutateur à semi-conducteurs (104 ; 304) de l'état conducteur à l'état non conducteur, le signal de commande (112) ayant une deuxième vitesse de balayage prédéfinie, ladite deuxième vitesse de balayage prédéfinie étant supérieure à ladite première vitesse de balayage, puis la commutation, en utilisant le signal de commande (112), du commutateur à semi-conducteurs (104 ; 304) de l'état non conducteur à l'état conducteur, le signal de commande (112) ayant une deuxième vitesse de balayage prédéfinie, et
- si ledit courant de crête électrique est inférieur audit niveau de courant de crête maximal prédéfini, la commutation, à l'aide du signal de commande (112), du commutateur à semi-conducteurs (104 ; 304), le signal de commande (112) ayant la première vitesse de balayage prédéfinie.

9. Procédé selon la revendication 8, comprenant en outre les étapes de :
- surveillance de la durée de la commutation du commutateur à semi-conducteurs en utilisant ladite deuxième vitesse de balayage, et
- la commutation du commutateur à semi-conducteurs à l'état non conducteur si la durée est supérieure à une première période de temps prédéfinie.

10. Procédé selon une quelconque des revendications 8 à 9, comprenant en outre la commutation à nouveau du commutateur à semi-conducteurs en utilisant la première vitesse de balayage prédéfinie, s'il est déterminé que le niveau de courant de crête électrique a été inférieur au niveau de courant de crête maximum prédéfini pendant une période de temps prédéterminée.

11. Procédé selon une quelconque des revendications 8 à 9, comprenant en outre l'étape de maintien du commutateur à semi-conducteurs dans l'état non conducteur pendant une deuxième période de temps prédéfinie avant de commuter le commutateur à semi-conducteur à l'état conducteur.
